# EUROPÄISCHE PATENTSCHRIFT

(11) **EP 3 499 253 B1**
(45) Veröffentlichungstag und Bekanntmachung des Hinweises auf die Patenterteilung: **10.08.2022**
(21) Anmeldenummer: 18000965.6
(22) Anmeldetag: 12.12.2018
(51) Int. Cl.: G01R 31/08, G01R 31/12

(54) **SEEKABELSTRECKE UND VERFAHREN ZUR ERMITTLUNG EINER ELEKTRISCHEN TEILENTLADUNG IN EINER SEEKABELSTRECKE**
SUBMARINE CABLE SECTION AND METHOD FOR DETERMINING A PARTIAL ELECTRICAL DISCHARGE IN A SUBMARINE CABLE SECTION
TRAJET DE CÂBLE SOUS-MARIN ET PROCÉDÉ DE DÉTERMINATION D'UNE DÉCHARGE PARTIELLE ÉLECTRIQUE DANS UN TRAJET DE CÂBLE SOUS-MARIN

(30) Priorität: 18.12.2017 DE 102017011671
(43) Veröffentlichungstag der Anmeldung: 19.06.2019
(73) Patentinhaber: Norddeutsche Seekabelwerke GmbH, 26954 Nordenham (DE)
(72) Erfinder: Beigert, Michael, 45355 Essen (DE); Ottersberg, Heiner, 26639 Wiesmoor (DE)
(74) Vertreter: Möller, Friedrich

(56) Entgegenhaltungen:
- WO-A1-2017/144091
- CN-A- 106 124 940

## Beschreibung

Die Erfindung betrifft eine Seekabelstrecke gemäß Anspruch 1. Des Weiteren betrifft die Erfindung ein Verfahren zur Ermittlung einer elektrischen Teilentladung in einer Seekabelstrecke gemäß Anspruch 8.

Zur Übertragung von elektrischer Energie zwischen einem Offshore-Windpark und dem Festland werden Seekabel auf dem Grund des Meeres verlegt bzw. in den Meeresgrund eingepflügt. Außerdem werden Seekabel verwendet, um eine elektrische Energieversorgung zwischen zwei Orten, die durch ein Gewässer voneinander getrennt sind, zu gewährleisten.

Um zwei Enden zweier Seekabelabschnitte eines Seekabels miteinander zu verbinden, werden Seekabel-Muffen als Verbindungselemente verwendet. In diesen Seekabel-Muffen, die hülsenartig ausgebildet sind, werden die beiden Enden der Seekabelabschnitte elektrisch leitend miteinander verbunden. Damit die Verbindungen der Seekabelabschnitte vor jeglichen Umwelteinflüssen geschützt sind, bildet die Muffe um die Schnittstelle eine luft- sowie wasserundurchlässige Umhüllung. Je nach Art des Seekabels kann es sich bei der Muffe um eine Einleiter- oder Dreileiter-Seekabel-Muffe handeln.

Neben der Verbindung zweier loser Enden der Seekabelabschnitte können Muffen auch eingesetzt werden, um Beschädigungen an dem Seekabel zu beheben.

Insbesondere bei der Verbindung der Enden der Seekabelabschnitte können Fehler in der elektrischen Verbindung auftreten, die sofort oder schleichend zu Teilentladungen führen können. Sobald die Enden der Kabelabschnitte von der Muffe umschlossen sind, ist ein Nachweis von Teilentladungen nur indirekt möglich. Als besonders problematisch stellt sich der Nachweis einer Teilentladung in einer Muffe dar, wenn das Seekabel bereits verlegt, insbesondere eingepflügt, ist. Ein Beispiel einer Seekabelstrecke ist in WO 2017/144091 A1 offenbart.

Davon ausgehend liegt der Erfindung, die durch die Merkmale der unabhängigen Ansprüche definiert ist, die Aufgabe zugrunde, eine Seekabelstrecke sowie ein Verfahren zur Ermittlung einer elektrischen Teilentladung in einer Seekabelstrecke zu schaffen, mit dem der Nachweis einer Teilentladung in einer Seekabel-Muffe auf eine besonders einfache und zuverlässige Art und Weise realisierbar ist.

Eine Lösung dieser Aufgabe wird durch die Merkmale des Anspruchs 1 beschrieben. Demnach ist es vorgesehen, dass vor und hinter der Seekabel-Muffe an den beiden Seekabelabschnitten jeweils ein kapazitiver Sensor befestigt ist, wobei die beiden kapazitiven Sensoren durch ein Dielektrikum von den Seekabelabschnitten getrennt und von einer Schutzhülle ummantelt sind. Außerdem sieht die Erfindung mindestens einen Signalwandler vor, welcher der Seekabelstrecke zugeordnet ist und von dem die elektrischen Signale der kapazitiven Sensoren in optische Signale umwandelbar sind. Durch die beiden kapazitiven Sensoren lassen sich Teilentladungen innerhalb der Seekabel-Muffe nachweisen. Eine Teilentladung innerhalb der Muffe führt zu einer Veränderung der durch die beiden Sensoren gemessenen Kapazität. Derartige Entladungen können beispielsweise hervorgerufen werden durch eine fehlerhafte Kopplung der beiden Enden der Seekabelabschnitte oder durch einen Fehler in der elektrischen Isolierung der stromführenden Leitungen.

Damit die Sensoren vor Umwelteinflüssen, wie beispielsweise Salzwasser geschützt sind, sind sie durch eine Schutzhülle ummantelt. Bei dieser Schutzhülle kann es sich beispielsweise um einen Schrumpfschlauch handeln. Die durch die kapazitiven Sensoren ausgekoppelten Signale sind durch einen nachgeordneten Signalwandler umwandelbar in optische Signale. Die Verwendung der optischen Signale liefert eine Vielzahl von Vorteilen, wie beispielsweise eine erhöhte Übertragungsgeschwindigkeit, ein größeres Datenvolumen, was übertragen werden kann, sowie einen sehr störungsarmen Übertrag von Daten.

Insbesondere kann es die vorliegende Erfindung weiter vorsehen, dass die kapazitiven Sensoren durch stromleitende Kabel, insbesondere BNC-Kabel, jeweils mit einem Signalwandler verbunden sind und die Signalwandler durch Lichtwellenleiter mit einer Messeinrichtung gekoppelt sind. Die kapazitiven Sensoren werden zum einen direkt mit einem stromleitenden Kabel verbunden. Gleichzeitig können die Sensoren bzw. das BNC-Kabel mit einem Erdpotential verbunden werden. Außerdem ist es vorgesehen, dass die stromleitenden Kabel möglichst kurz gehalten werden und in einem Signalwandler in optische Signale konvertiert werden. Dabei ist vorzugsweise jedem Sensor ein Signalwandler zugeordnet. Diese Signalwandler können entweder in das Seekabel bzw. in die Muffe integriert sein oder extern an der Seekabelstrecke positioniert werden.

Bevorzugt kann es die vorliegende Erfindung weiter vorsehen, dass die Lichtwellenleiter in das Seekabel integriert sind und ggf. zwei offene Enden der Lichtwellenleiter in der Seekabel-Muffe miteinander verbunden sind. Zum Analysieren der durch die kapazitiven Sensoren gemessenen Signale vor dem Verlegen des Kabels können die Lichtwellenleiter direkt an einer Messeinrichtung, wie beispielsweise einem Oszilloskop, angeschlossen werden. Für den Fall, dass die Seekabelstrecke nach dem Verlegen hinsichtlich Teilentladungen untersucht werden soll, sind die Lichtwellenleiter in das Seekabel zu integrieren. Um Lichtwellenleiter von zwei zusammenzuschließenden Seekabelabschnitten ebenfalls zu koppeln, ist es vorgesehen, dass in den Seekabel-Muffen Lichtleitermuffen integriert sind, durch die zwei Enden der Lichtleiter miteinander gekoppelt werden, ohne dass ein Verlust an Signalstärke entsteht. Der Lichtwellenleiter wird dabei entweder lediglich zu einem Ende des Seekabels geführt oder zu beiden Enden.

Ein weiteres Ausführungsbeispiel der vorliegenden Erfindung kann es vorsehen, dass um wenigstens ein Seekabelabschnitt mindestens eine Spule angeordnet ist zur Erzeugung elektrischer Energie für die Signalwandler, wobei die mindestens eine Spule durch ein Kabel mit den Signalwandlern verbunden ist. Sofern durch das Seekabel Wechselstrom transportiert wird, kann über Induktion in der Spule ein elektrischer Strom generiert werden, der ausreicht, um die Signalwandler mit elektrischer Energie zu versorgen. Solange das Seekabel nicht verbaut ist, lassen sich die Signalwandler auch mit konventionellen Spannungsquellen versorgen. Die Spulen zur induktiven Energieversorgung der Spannungswandler können dabei in einem Mantel des Seekabels integriert sein. Außerdem kann es vorgesehen sein, dass die Spule um das Seekabel herum gewickelt und anschließend, ähnlich wie die kapazitiven Sensoren, durch eine Schutzhülle umschlagen wird. Den Anforderungen entsprechend, kann die Spule eine beliebige Anzahl von Windungen aufweisen. Die Leitung von der Spule zu den Signalwandlern für die Versorgung selbiger mit elektrischer Energie kann ebenfalls in das Kabel integriert sein oder auf eine andere Art und Weise um das Seekabel verlegt werden. Durch die Verwendung der Spule kann der mindestens eine Signalwandler unabhängig von externen Energiequellen betrieben werden. Es braucht daher keine weitere Leitung in das Seekabel integriert zu werden, durch die von Land elektrische Energie zur Versorgung der Signalwandler transportiert werden muss. Die zur Versorgung der Signalwandler benötigte Energie ist dabei so gering, dass sie nicht zu einer signifikanten Verminderung der durch das Seekabel transportierten Energie führt. Darüber hinaus kann es erfindungsgemäß vorgesehen sein, dass die kapazitiven Sensoren als Metallbleche oder Metallfolien, vorzugsweise Kupferbleche bzw. Kupferfolien, ausgebildet sind, die wenigstens teilweise um einen Umfang der Seekabelabschnitte legbar sind. Die Metallbleche bzw. Folien können vorzugsweise eine Dimension von 120 mm x 200 mm aufweisen. Die Dicke der Bleche bzw. Folien ist gerade derart bemessen, dass diese ohne großen Kraftaufwand um die äußere Mantelfläche des Seekabels legbar sind. Dabei kann das Blech bzw. die Folie die Mantelfläche voll umschließen oder nur abschnittsweise. Vorteilhafterweise kann es vorgesehen sein, dass zwischen dem Seekabel und dem Blech bzw. der Folie als ein Dielektrikum Moosgummi gelegt wird. Die Metallbleche bzw. Folien sind zur Detektion der Teilentladungen direkt hinter den Enden der Seekabel-Muffe oder in einem geringen Abstand zu dieser zu positionieren.

Weiter kann es erfindungsgemäß vorgesehen sein, dass wenigstens einem Ende des Seekabels ein Pulsgenerator zur Erzeugung eines definierten elektrischen Kalibrierungspulses zugeordnet ist. Insbesondere vor dem Verlegen des Seekabels wird die Muffe oder die Muffen auf ihre Funktionsfähigkeit hin geprüft. Dazu wird ein definierter elektrischer Puls durch die Seekabelstrecke bzw. durch die Seekabel-Muffe geführt, um eventuelle Teilentladungen schon vor dem Verlegen zu entdecken. Des Weiteren dient die Beaufschlagung des Kabels mit einem definierten Puls dazu, die gesamte Messeinrichtung zu kalibrieren. Der elektrische Puls kann dabei eine Stärke von einigen wenigen bis hunderten von pC aufweisen.

Bevorzugt handelt es sich bei der Seekabel-Mutte um eine Hochspannungs-Einleiterseekabel-Muffe oder um eine Hochspannung-Dreileiterseekabel-Muffe. Es ist jedoch auch denkbar, dass die Erfindung auf Seekabelstrecken zur Übertragung von Informationen, also Datenleitungen, angewendet wird und die Muffen dementsprechend konfiguriert sind.

Eine weitere Lösung der eingangs genannten Aufgabe wird durch die Maßnahmen des Anspruchs 8 beschrieben. Demnach ist es vorgesehen, dass die oder jede Teilentladung in der Seekabel-Muffe durch kapazitive Sensoren vor und hinter den beiden Seiten der Seekabel-Muffe an den Seekabelabschnitten gemessen werden und anhand der Signale der kapazitiven Sensoren von einer Messeinrichtung eine Position der Teilentladung in der Seekabel-Muffe ermittelt wird. Diese Art der Messung eignet sich nicht nur für den Nachweis von Teilentladungen vor dem Verlegen des Seekabels, sondern insbesondere auch nach dem Verlegen des Seekabels. Da die kapazitiven Sensoren direkt in das Seekabel integrierbar sind bzw. an einer Außenwandung anbringbar sind, lässt sich die Teilentladung auf eine besonders einfache und zuverlässige Art und Weise bestimmen. Durch die Bestimmung der Position der Teilentladung lässt sich sogleich feststellen, an welcher Stelle beispielsweise die Isolierung der Leitungen defekt ist und ausgetauscht werden muss. Da in der Regel ein Seekabel bzw. eine Seekabelstrecke eine Vielzahl von Seekabel-Muffen aufweist, lässt sich durch das hier beanspruchte Verfahren für jede Seekabel-Muffe eine eventuelle Teilentladung und deren Position genau bestimmen, und zwar auch nach dem Verlegen des Seekabels auf oder in den Untergrund eines Gewässers.

Darüber hinaus besteht eine vorteilhafte Weiterbildung der Erfindung darin, dass vor der Inbetriebnahme des Seekabels selbiges mit mindestens einem definierten elektrischen Puls zur Kalibrierung der Messeinrichtung beaufschlagt wird und die Teilentladung von den kapazitiven Sensoren außerhalb der Muffe detektiert wird. Durch die Kalibrierung der Messeinrichtung vor dem Verlegen des Seekabels bzw. vor Inbetriebnahme des Seekabels kann die Nachweisgenauigkeit der Einrichtung für den späteren Betrieb optimiert werden. Darüber hinaus kann bereits während der Kalibrierung eine eventuelle Teilentladung nachgewiesen werden. Durch die Kalibrierung lässt sich für jede einzelne Seekabel-Muffe des Seekabels bzw. Seekabelstrecke ein optimales Signal erstellen bzw. die Empfindlichkeit der Messeinrichtung für den Nachweis einer Teilentladung optimiert werden.

Bevorzugterweise kann es außerdem vorgesehen sein, dass während des Betriebs des Seekabels, Teilentladungen, die durch einen an dem Seekabel anliegenden elektrischen Strom, vorzugsweise Wechselstrom, erzeugt werden, von den kapazitiven Sensoren außerhalb der Muffe detektiert werden. Bei der Leitung eines Wechselstromes ändert sich die Polarität des transportierten Stroms periodisch. Bei einem Defekt in der elektrischen Isolierung führt dies ebenfalls zu einer periodischen Veränderung der durch die kapazitiven Sensoren gemessenen Kapazität. Insbesondere durch den mechanischen Defekt kann elektrische Ladung aus dem inneren Leiter des Seekabels in die Isolierung entweichen. Durch dieses Entweichen einer Teilentladung ändert sich das elektrische Feld zwischen dem Kabel und dem kapazitiven Sensor, was von selbigem messbar ist. Eine weitere vorteilhafte Maßnahme der Erfindung sieht es vor, dass durch eine Laufzeitmessung der gemessenen Signale von den Sensoren zu der Messeinrichtung die Positionen der Teilentladungen in der Seekabel-Muffe von der Messeinrichtung ermittelt werden. Da die Teilentladungen in der Regel in der Seekabel-Muffe entstehen, die kapazitiven Sensoren jedoch außerhalb der Muffe positioniert sind, vergeht eine charakteristische Zeit von dem eigentlichen Ereignis der Entladung bis zu dem Nachweis der Entladung durch die kapazitiven Sensoren außerhalb der Muffe. Bei Kenntnis der Frequenz des Wechselstroms bzw. bei Kenntnis der Zeitstruktur des definierten Kalibrierungspulses kann somit eine Laufzeit zwischen dem Ereignis und dem Nachweis ermittelt werden. Sofern die Teilentladung genau in der Mitte der Muffe erfolgt, wird dieses Ereignis durch beide kapazitiven Sensoren, sofern sie dann im gleichen Abstand zur Mitte auf dem Kabel positioniert sind, gemessen. Erfolgt das Ereignis der Teilentladung jedoch näher zu dem einen oder dem anderen Ende der Muffe, so wird die Entladung von einem Sensor eher gemessen als von dem anderen. Die Signale werden somit nacheinander durch die Messeinrichtung, wie beispielsweise einem Oszilloskop, nachgewiesen. Durch diese Zeitdifferenz ist mit einer hohen Genauigkeit feststellbar, an welcher Position in der Muffe die Entladung erfolgt. Dies ist insbesondere für die Fehlerbehebung eine wichtige Information.

Die Erfindung gemäß Anspruch 8 sieht vor, versehen) dass die von den kapazitiven Sensoren bei einer Teilentladung gemessenen elektrischen Signale von Signalwandlern umgewandelt werden in optische Signale, die durch Lichtwellenleiter, insbesondere durch das Seekabel, zu der Messeinrichtung transportiert werden, wobei die elektrischen Signale von den Sensoren zu den Signalwandlern durch Kabel, vorzugsweise BNC-Kabel, transportiert werden.

Schließlich besteht eine weitere bevorzugte Weiterentwicklung darin, dass durch mindestens eine Spule, die um mindestens ein Ende eines Seekabelabschnitts des Seekabels angeordnet ist, elektrische Energie zur Versorgung der Signalwandler erzeugt wird. Insbesondere bei dem Transport einer Wechselspannung, wird in der Spule ein elektrischer Strom induziert, der ausreicht, um die Signalwandler mit elektrischer Energie zu versorgen. Je nach Anwendung bzw. Anforderungen oder in Abhängigkeit von der zu generierenden elektrischen Energie kann die Anzahl der Windungen der Spule nahezu beliebig festgelegt werden, ohne dass dadurch die durch das Seekabel transportierte Energie in einem signifikanten Maße reduziert werden würde. Es ist außerdem denkbar, dass die Spule neben den Signalwandlern auch andere elektrische Komponenten mit elektrischer Energie versorgt.

Bevorzugte Ausführungsbeispiele der vorliegenden Erfindung werden nachfolgend anhand der Zeichnung näher erläutert. In dieser zeigen:
- Fig. 1: eine schematisierte Darstellung eines Seekabelabschnitts, an dem eine Kalibrierung durchgeführt wird, und
- Fig. 2: eine schematisierte Darstellung des Nachweises einer Teilentladung an einer verlegten Seekabelstrecke.

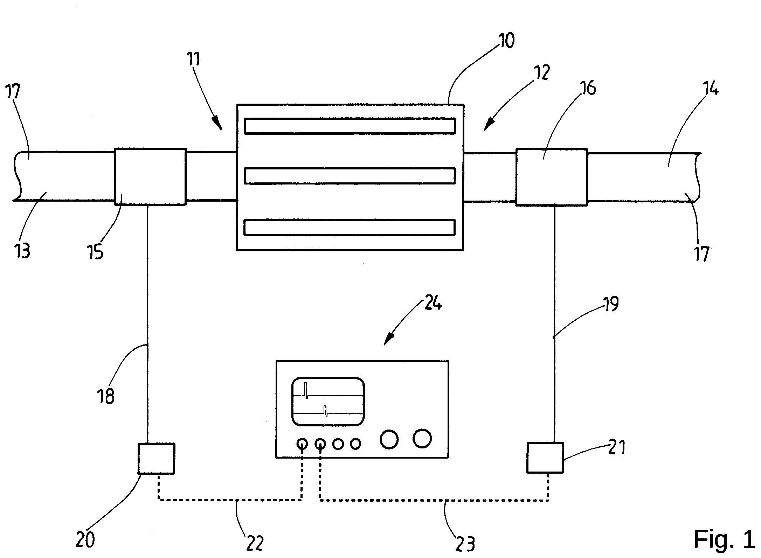

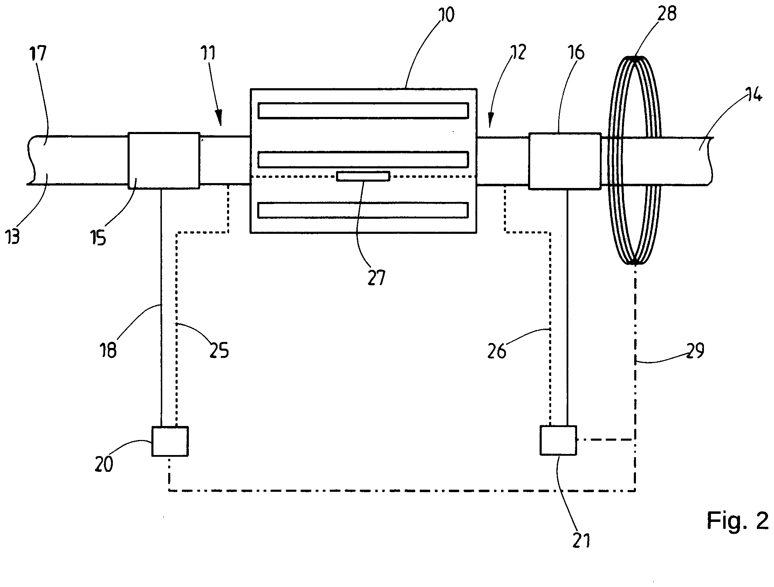

Die Fig. 1 und 2 zeigen einen Abschnitt einer Seekabelstrecke, bei dem eine Seekabel-Muffe 10 zwei Enden 11, 12 zweier Seekabelabschnitte 13, 14 miteinander verbindet. Seekabel der hier beschriebenen Art dienen primär der Übertragung von elektrischer Energie von beispielsweise einem Offshore-Windpark zu einer Landstation oder zum Transport elektrischer Energie zwischen zwei Landstationen, die durch ein Gewässer, wie beispielsweise ein Meer, voneinander getrennt sind. Dazu werden die Seekabel auf dem Untergrund des Meeres verlegt, insbesondere in den Untergrund eingepflügt.

Damit die Seekabel den Umwelteinflüssen über eine möglichst lange Zeitdauer standhalten können, weisen die Kabel eine entsprechende Armierung auf. Problematisch sind jedoch Verbindungsstellen, bei denen die Enden 11, 12 von Seekabelabschnitten 13, 14 miteinander verbunden werden. Derartige Verbindungen werden durch die in den Fig. 1 und 2 dargestellten Seekabel-Muffen 10 gewährleistet. Um sowohl vor dem Verlegen bzw. vor der Inbetriebnahme des Seekabels aber auch während des Betriebs die Verbindungen der Seekabelabschnitte 13 und 14 auf ihre fehlerfreie Funktion zu überprüfen, werden erfindungsgemäß an den Seekabelabschnitten 13 und 14 vor und hinter der Seekabel-Muffe 10 kapazitive Sensoren 15, 16 um den Mantel der Seekabelabschnitte 13, 14 gelegt. Bei diesen kapazitiven Sensoren 15, 16 handelt es sich um Metallbleche oder Folien aus vorzugsweise Kupfer. Zwischen dem Mantel 17 und den Sensoren 15, 16 kann zusätzlich ein isolierendes Material, wie beispielsweise Moosgummi, positioniert werden. Um auch die kapazitiven Sensoren 15, 16 vor Umwelteinflüssen zu schützen bzw. elektrisch zu isolieren, werden die Sensoren 15, 16 nach ihrer Installation um die Seekabelabschnitte 13, 14 mit einer Ummantelung, wie beispielsweise einem Schrumpfschlauch versehen.

Es ist jedoch auch möglich, dass die Sensoren mit einem anderen Material, wie beispielsweise einem Harz, umgossen werden.

Die kapazitiven Sensoren 15, 16 sind jeweils über ein Kabel 18, 19 mit Signalwandlern 20, 21 verbunden. Bei den Kabeln 18, 19 kann es sich vorzugsweise um BNC-Kabel handeln, da sie eine besonders rauscharme Übertragung von elektrischen Signalen gewährleisten.

Durch die Signalwandler 20, 21 kann ein elektrisches Signal der kapazitiven Sensoren 15, 16 in ein optisches Signal umgewandelt werden. Diese optischen Signale werden sodann über Lichtwellenleiter 22, 23 an eine Messeinrichtung 24 übertragen. Bei der in Fig. 1 dargestellten Messeinrichtung 24 handelt es sich um ein Oszilloskop. Darüber hinaus ist es jedoch auch denkbar, dass die Messeinrichtung 24 als ein Transienten-Rekorder oder dergleichen ausgebildet ist.

Das in der Fig. 1 dargestellte Ausführungsbeispiel dient hauptsächlich dazu, Teilentladungen, die bei einer fehlerhaften Verbindung der Seekabelenden 11, 12 oder bei einem Defekt der Isolierung auftreten, bereits vor dem Verlegen des Seekabels zu detektieren. Dazu wird in einem der Seekabelabschnitte 13, 14 ein definierter elektrischer Puls gesendet. Dabei wird jeder Leiter des Seekabels einzeln mit dem Puls beaufschlagt. Sofern innerhalb der Muffe eine Teilentladung stattfindet, wird die durch die Teilentladung verursachte Änderung der Kapazität von den kapazitiven Sensoren 15, 16 gemessen.

Sofern keine Teilentladung stattfindet, ändert sich das von den Sensoren 15, 16 gemessene elektrische Feld zwischen den Sensoren und dem Kabel nicht. Sofern jedoch elektrische Ladungen von den Leitern beispielsweise in die Isolierung treten, wird durch die Sensoren 15, 16 eine Änderung der Feldstärke bzw. der Kapazität gemessen. Diese Änderungen der Kapazitäten werden durch elektrische Signale von den kapazitiven Sensoren 15, 16 durch die Kabel 18, 19 an die Signalwandler 20, 21 gesendet, von denen diese sodann als optische Pulse an die Messeinrichtung 24 weitergeleitet werden. In der Messeinrichtung 24 werden die Signale der Sensoren 15, 16 jeweils auf einem Kanal ausgelesen und, wie beispielsweise in der Fig. 1 dargestellt, auf einem Display angezeigt. Durch die Messung der Änderung in der Kapazität lässt sich zunächst feststellen, dass eine Teilentladung stattfand, was auf eine fehlerhafte Verbindung bzw. einen Defekt in der Isolierung schließen lässt.

Durch die Positionierung der kapazitiven Sensoren 15, 16 in einem definierten Abstand zu der Seekabel-Muffe 10 lässt sich nun anhand einer Zeitdifferenz zwischen den beiden mit der Messeinrichtung 24 gemessenen Signalen der Ort der Teilentladung in der Seekabel-Muffe 10 bestimmen. Sofern beispielsweise die Entladung in der Mitte der Seekabel-Muffe 10, also dort wo die beiden Seekabelabschnitte 13, 14 miteinander verbunden werden, auftritt, beträgt die Laufzeitdifferenz zwischen den beiden durch die Messeinrichtung 24 aufgenommenen Signale gleich Null. Tritt die Entladung jedoch an einer anderen Stelle auf, so ist die Laufzeitdifferenz ungleich Null. Durch die Reihenfolge, mit der die gemessenen Signale durch die Messeinrichtung erfasst werden, kann nicht nur der Abstand zu dem Mittelpunkt der Muffe festgestellt werden, sondern auch die Richtung bzw. die genaue Position.

Da nun ein Seekabel eine Vielzahl von Seekabel-Muffen 10 aufweist, die erfindungsgemäß alle mit kapazitiven Sensoren 15, 16 ausgestattet sind, lassen sich Teilentladungen auf die hier dargestellte Art und Weise nicht nur über eine Seekabel-Muffe 10 messen, sondern auch über die Seekabelabschnitte 13, 14 zwischen den Muffen. Dazu werden Signale analysiert, die von kapazitiven Sensoren aufgenommen werden, die jeweils vor bzw. hinter zwei benachbarten Seekabel-Muffen positioniert sind.

Sofern während der zuvor beschriebenen Prüfung auf Teilentladungen während oder vor des Einbaus des Seekabels ein Fehler festgestellt wurde, kann dieser noch vor dem Einbau behoben werden.

Darüber hinaus dient die in Fig. 1 dargestellte Prüfmethode auch einer Kalibrierung der kapazitiven Sensoren 15, 16 sowie der Signalwandler 20, 21 und dem Messsystem. Selbst wenn keine Teilentladung festgestellt werden konnte, so kann anhand des definierten Pulses die Messeinrichtung derart optimiert werden, um ein möglichst großes Signal/Rausch-Verhältnis zu generieren.

Sobald das Seekabel jedoch auf dem Untergrund verlegt wurde, ist das zuvor beschriebene Verfahren zur Ermittlung elektrischer Teilentladung in einer Seekabelstrecke nicht mehr durchführbar. Da jedoch auch während des Betriebs oder insbesondere während des Verlegens des Seekabels durch mechanische oder auch elektromagnetische Kräfte die Verbindung der Seekabelabschnitte 13, 14 oder das Seekabel selbst beschädigt werden kann, besteht eine Notwendigkeit auch während des Betriebs das Seekabel auf eventuelle Teilentladungen hin zu untersuchen.

Die Fig. 2 zeigt genau wie die Fig. 1 zwei Seekabelabschnitte 13, 14 die durch eine Seekabel-Muffe 10 miteinander verbunden sind. Des Weiteren sind auch den in Fig. 2 dargestellten Seekabelabschnitten 13, 14 jeweils kapazitive Sensoren 15, 16 zugeordnet, welche über Kabel 18, 19 mit Signalwandlern 20, 21 verbunden sind. Um nun jedoch die durch die Sensoren 15, 16 gemessenen Signale einer Teilentladung an eine Messeinrichtung zu führen, die vorzugsweise am Festland positioniert ist, muss das durch die Signalwandler 20, 21 generierte optische Signal durch Lichtwellenleiter 25, 26 an die Wasseroberfläche geführt werden. Dazu ist es vorgesehen, dass die Lichtwellenleiter 25, 26 in das Seekabel integriert sind und so an die Wasseroberfläche geführt werden. Dabei werden die Lichtwellenleiter 25, 26 in der Seekabel-Muffe 10 durch eine Lichtwellenleitermuffe 27 miteinander gekoppelt. Eine derartige Kopplung der Lichtwellenleiter erfolgt in jeder weiteren Seekabel-Muffe.

Um die Signalwandler 20, 21 mit elektrischer Energie zu versorgen, ist wenigstens einem Seekabelabschnitt 13, 14 eine Spule 28 zugeordnet. Sofern durch das Seekabel ein Wechselstrom transportiert wird, kann durch die induktive Wirkung des Wechselstroms in den Windungen der Spule 28 eine elektrische Spannung erzeugt werden, welche dazu dient, die Signalwandler 20, 21 mit elektrischer Energie zu versorgen. Dazu ist die Spule 28 über ein Kabel 29 mit den Signalwandlern 20, 21 verbunden.

An dieser Stelle sei ausdrücklich darauf hingewiesen, dass die in den Fig. 1 und 2 dargestellten Ausführungsbeispiele stark schematisiert sind. Insbesondere die Signalwandler 20, 21 sind bei den beanspruchten Ausführungsformen vorzugsweise in die Muffe 10 bzw. in das Seekabel integriert. Auch die in der Fig. 2 dargestellte Spule 28 ist zu Anschauungszwecken überdimensional dargestellt. Bevorzugt ist es vielmehr vorgesehen, dass die Windungen bzw. die Wendel der Spule 28 direkt auf dem Mantel 17 der Seekabelabschnitte 13, 14 positioniert sind und dort eine entsprechende elektrische Isolierung bzw. Schutzhülle aufweisen.

Durch das in der Fig. 2 dargestellte Ausführungsbeispiel der Erfindung lässt sich sowohl die Muffe 10 als auch Seekabelabschnitte 13, 14 während des Betriebs auf Teilentladungen hin untersuchen. Da die Energie für diese Messung direkt aus der übertragenen Hochspannung gezogen wird, kann eine kontinuierliche Überprüfung erfolgen.

### Bezugszeichenliste:

- 10: Seekabel-Muffe
- 11: Ende
- 12: Ende
- 13: Seekabelabschnitt
- 14: Seekabelabschnitt
- 15: kapazitiver Sensor
- 16: kapazitiver Sensor
- 17: Mantel
- 18: Kabel
- 19: Kabel
- 20: Signalwandler
- 21: Signalwandler
- 22: Lichtwellenleiter
- 23: Lichtwellenleiter
- 24: Messeinrichtung
- 25: Lichtwellenleiter
- 26: Lichtwellenleiter
- 27: Lichtwellenleitermuffe
- 28: Spule
- 29: Kabel

## Patentansprüche

1. Seekabelstrecke mit einer Seekabel-Muffe (10) zur Verbindung von zwei Enden (11, 12) zweier Seekabelabschnitte (13, 14) eines Seekabels, wobei eine oder jede Teilentladung in der Seekabel-Muffe (10) durch zwei kapazitive Sensoren (15, 16) vor und hinter den beiden Seiten der Seekabel-Muffe (10) messbar ist, wobei
eine Messeinrichtung (24) der Seekabelstrecke eingerichtet ist, anhand elektrischer Signale der Sensoren (15, 16) eine Position der jeweiligen Teilentladung in der Seekabel-Muffe (10) zu ermitteln,
wobei die Sensoren (15, 16) vor und hinter der Seekabel-Muffe (10) an den beiden Seekabelabschnitten (13, 14) befestigt sind und wobei die beiden kapazitiven Sensoren (15, 16) durch ein Dielektrikum von den Seekabelabschnitten (13, 14) getrennt und von einer Schutzhülle ummantelt sind, und der Seekabelstrecke mindestens ein Signalwandler (20, 21) zugeordnet ist, von dem die elektrischen Signale der kapazitiven Sensoren (15, 16) in optische Signale umwandelbar sind.

2. Seekabelstrecke nach Anspruch 1, **dadurch gekennzeichnet, dass** die kapazitiven Sensoren (15, 16) durch stromleitende Kabel (18, 19), insbesondere BNC-Kabel, jeweils mit einem der Signalwandler (20, 21) verbunden sind und die Signalwandler (20, 21) durch Lichtwellenleiter (22, 23, 25, 26) mit einer Messeinrichtung (24) gekoppelt sind.

3. Seekabelstrecke nach Anspruch 2, **dadurch gekennzeichnet, dass** die Lichtwellenleiter (22, 23, 25, 26) in das Seekabel integriert sind und gegebenenfalls zwei offene Enden der Lichtwellenleiter (25, 26) in der Seekabel-Muffe (10) miteinander verbunden sind.

4. Seekabelstrecke nach einem der vorhergehenden Ansprüche, **dadurch gekennzeichnet, dass** um wenigstens einen Seekabelabschnitt (13, 14) mindestens eine Spule (28) angeordnet ist zur Erzeugung elektrischer Energie für die Signalwandler (20, 21), wobei die mindestens eine Spule (28) durch ein Kabel (29) mit den Signalwandlern (20, 21) verbunden ist.

5. Seekabelstrecke nach einem der vorhergehenden Ansprüche, **dadurch gekennzeichnet, dass** die kapazitiven Sensoren (15, 16) als Metallbleche oder Metallfolien, vorzugsweise Kupferbleche bzw. Kupferfolien, ausgebildet sind, die wenigstens teilweise um einen Umfang der Seekabelabschnitte (13, 14) legbar sind.

6. Seekabelstrecke nach einem der vorhergehenden Ansprüche, **dadurch gekennzeichnet, dass** wenigstens einem Ende des Seekabels ein Pulsgenerator zur Erzeugung eines definierten elektrischen Kalibrierungspulses zugeordnet ist.

7. Seekabelstrecke nach einem der vorhergehenden Ansprüche, **dadurch gekennzeichnet, dass** es sich bei der Seekabel-Muffe (10) um eine Hochspannungs-Einleiter-Seekabel-Muffe oder um eine Hochspannungs-Dreileiter-Seekabel-Muffe handelt.

8. Verfahren zur Ermittlung elektrischer Teilentladungen in einer Seekabelstrecke mit einer Seekabel-Muffe (10), durch welche die Enden (11, 12) zweier Seekabelabschnitte (13, 14) eines Seekabels miteinander verbunden werden, wobei eine oder jede Teilentladung in der Seekabel-Muffe (10) durch kapazitive Sensoren (15, 16) vor und hinter den beiden Seiten der Seekabel-Muffe (10) gemessen werden,
wobei anhand der elektrischen Signale der kapazitiven Sensoren (15, 16) von einer Messeinrichtung (24) eine Position der jeweiligen Teilentladung in der Seekabel-Muffe (10) ermittelt wird, wobei die beiden kapazitiven Sensoren (15, 16) vor und hinter der Seekabel-Muffe (10) an den beiden Seekabelabschnitten (13, 14) befestigt sind, und wobei die Sensoren (15, 16) durch ein Dielektrikum von den Seekabelabschnitten (13, 14) getrennt und von einer Schutzhülle ummantelt sind, und wobei die elektrischen Signale von den Sensoren (15, 16) durch Kabel (18, 19) zu Signalwandlern (20, 21) transportiert werden und die gemessenen elektrischen Signale von den Signalwandlern (20, 21) umgewandelt werden in optische Signale, die durch Lichtwellenleiter (22, 23, 25, 26) zu der Messeinrichtung (24) transportiert werden.

9. Verfahren nach Anspruch 8, **dadurch gekennzeichnet, dass** vor der Inbetriebnahme des Seekabels selbiges mit mindestens einem definierten elektrischen Puls zur Kalibrierung der Messeinrichtung (24) beaufschlagt wird und die Teilentladung von den kapazitiven Sensoren (15, 16) außerhalb der Muffe (10) detektiert wird.

10. Verfahren nach Anspruch 8 oder 9, **dadurch gekennzeichnet, dass** während des Betriebs des Seekabels, Teilentladungen, die durch einen an dem Seekabel anliegenden elektrischen Strom, vorzugsweise Wechselstrom, erzeugt werden, von den kapazitiven Sensoren (15, 16) außerhalb der Muffe (10) detektiert werden.

11. Verfahren nach einem der Ansprüche 8 bis 10, **dadurch gekennzeichnet, dass** durch eine Laufzeitmessung der gemessenen Signale von den Teilentladungen zu den Sensoren (15, 16) die Positionen der Teilentladungen in der Seekabel-Muffe (10) von der Messeinrichtung (24) ermittelt werden.

12. Verfahren nach einem der Ansprüche 8 bis 11, **dadurch gekennzeichnet, dass** die von den kapazitiven Sensoren (15, 16) bei einer Teilentladung gemessenen elektrischen Signale von Signalwandlern (20, 21) umgewandelt werden in optische Signale, die durch das Seekabel zu der Messeinrichtung (24) transportiert werden, wobei die elektrischen Signale von den Sensoren (15, 16) zu den Signalwandlern (20, 21) durch Kabel (18, 19), vorzugsweise BNC-Kabel, transportiert werden.

13. Verfahren nach einem der Ansprüche 8 bis 12, **dadurch gekennzeichnet, dass** durch mindestens eine Spule (28), die um mindestens ein Ende eines Seekabelabschnitts (13, 14) des Seekabels angeordnet ist, elektrische Energie zur Versorgung der Signalwandler (20, 21) erzeugt wird.

## Claims

1. Submarine cable link comprising a submarine cable coupling sleeve (10) for connecting two ends (11, 12) of two submarine cable sections (13, 14) of a submarine cable, wherein a or each partial discharge in the submarine cable coupling sleeve (10) is measurable by two capacitive sensors (15, 16) upstream and downstream of the two sides of the submarine cable coupling sleeve (10), wherein a measuring device (24) of the submarine cable link is configured to determine a position of the respective partial discharge in the submarine cable coupling sleeve (10) on the basis of electrical signals of the sensors (15, 16), wherein the sensors (15, 16) upstream and downstream of the submarine cable coupling sleeve (10) are secured to the two submarine cable sections (13, 14) and wherein the two capacitive sensors (15, 16) are separated from the submarine cable sections (13, 14) by a dielectric and are enclosed by a protective sheath, and the submarine cable link is assigned at least one signal transducer (20, 21) which enables the electrical signals of the capacitive sensors (15, 16) to be converted into optical signals.

2. Submarine cable link according to Claim 1, **characterized in that** the capacitive sensors (15, 16) are respectively connected to one of the signal transducers (20, 21) by current-conducting cables (18, 19), in particular BNC cables, and the signal transducers (20, 21) are coupled to a measuring device (24) by optical waveguides (22, 23, 25, 26).

3. Submarine cable link according to Claim 2, **characterized in that** the optical waveguides (22, 23, 25, 26) are integrated into the submarine cable and optionally two open ends of the optical waveguides (25, 26) are connected to one another in the submarine cable coupling sleeve (10).

4. Submarine cable link according to any of the preceding claims, **characterized in that** at least one coil (28) is arranged around at least one submarine cable section (13, 14) in order to generate electrical energy for the signal transducers (20, 21), wherein the at least one coil (28) is connected to the signal transducers (20, 21) by a cable (29) .

5. Submarine cable link according to any of the preceding claims, **characterized in that** the capacitive sensors (15, 16) are embodied as metal sheets or metal foils, preferably copper sheets or copper foils, which are able to be placed at least partly around a circumference of the submarine cable sections (13, 14).

6. Submarine cable link according to any of the preceding claims, **characterized in that** at least one end of the submarine cable is assigned a pulse generator for generating a defined electrical calibration pulse.

7. Submarine cable link according to any of the preceding claims, **characterized in that** the submarine cable coupling sleeve (10) is a high-voltage single-conductor submarine cable coupling sleeve or a high-voltage three-conductor submarine cable coupling sleeve.

8. Method for determining electrical partial discharges in a submarine cable link comprising a submarine cable coupling sleeve (10), by which the ends (11, 12) of two submarine cable sections (13, 14) of a submarine cable are connected to one another, wherein a or each partial discharge in the submarine cable coupling sleeve (10) is measured by capacitive sensors (15, 16) upstream and downstream of the two sides of the submarine cable coupling sleeve (10), wherein a position of the respective partial discharge in the submarine cable coupling sleeve (10) is determined by a measuring device (24) on the basis of the electrical signals of the capacitive sensors (15, 16), wherein the two capacitive sensors (15, 16) upstream and downstream of the submarine cable coupling sleeve (10) are secured to the two submarine cable sections (13, 14), and wherein the sensors (15, 16) are separated from the submarine cable sections (13, 14) by a dielectric and are enclosed by a protective sheath, and wherein the electrical signals are transported from the sensors (15, 16) to signal transducers (20, 21) by cables (18, 19) and the measured electrical signals are converted into optical signals by the signal transducers (20, 21), said optical signals being transported to the measuring device (24) by optical waveguides (22, 23, 25, 26).

9. Method according to Claim 8, **characterized in that** before the submarine cable is commissioned, at least one defined electrical pulse for calibrating the measuring device (24) is applied to said submarine cable and the partial discharge is detected by the capacitive sensors (15, 16) outside the coupling sleeve (10).

10. Method according to Claim 8 or 9, **characterized in that** during the operation of the submarine cable, partial discharges generated by an electric current, preferably AC current, present on the submarine cable are detected by the capacitive sensors (15, 16) outside the coupling sleeve (10).

11. Method according to any of Claims 8 to 10, **characterized in that** by means of a propagation time measurement of the measured signals from the partial discharges to the sensors (15, 16), the positions of the partial discharges in the submarine cable coupling sleeve (10) are determined by the measuring device (24).

12. Method according to any of Claims 8 to 11, **characterized in that** the electrical signals measured by the capacitive sensors (15, 16) in the case of a partial discharge are converted into optical signals by signal transducers (20, 21), said optical signals being transported to the measuring device (24) by the submarine cable, wherein the electrical signals are transported from the sensors (15, 16) to the signal transducers (20, 21) by cables (18, 19), preferably BNC cables.

13. Method according to any of Claims 8 to 12, **characterized in that** electrical energy for supplying the signal transducers (20, 21) is generated by at least one coil (28) arranged around at least one end of a submarine cable section (13, 14) of the submarine cable.

## Revendications

1. Tronçon de câble sous-marin comprenant un manchon de câble sous-marin (10) destiné à relier deux extrémités (11, 12) de deux portions de câble sous-marin (13, 14) d'un câble sous-marin, une ou chaque décharge partielle dans le manchon de câble sous-marin (10) pouvant être mesurée par deux capteurs capacitifs (15, 16) devant et derrière les deux côtés du manchon de câble sous-marin (10), un dispositif de mesure (24) du tronçon de câble sous-marin étant conçu pour déterminer une position de la décharge partielle respective dans le manchon de câble sous-marin (10) à l'aide des signaux électriques des capteurs (15, 16), les capteurs (15, 16) étant fixés devant et derrière le manchon de câble sous-marin (10) aux deux portions de câble sous-marin (13, 14) et les deux capteurs capacitifs (15, 16) étant séparés des portions de câble sous-marin (13, 14) par un diélectrique et étant revêtus d'une enveloppe protectrice, et au moins un convertisseur de signaux (20, 21) étant associé au tronçon de câble sous-marin, par lequel les signaux électriques des capteurs capacitifs (15, 16) peuvent être convertis en signaux optiques.

2. Tronçon de câble sous-marin selon la revendication 1, **caractérisé en ce que** les capteurs capacitifs (15, 16) sont respectivement reliés à l'un des convertisseurs de signaux (20, 21) par des câbles (18, 19) conducteurs électriques, notamment des câbles BNC, et les convertisseurs de signaux (20, 21) sont couplés à un dispositif de mesure (24) par des fibres optiques (22, 23, 25, 26).

3. Tronçon de câble sous-marin selon la revendication 2, **caractérisé en ce que** les fibres optiques (22, 23, 25, 26) sont intégrées dans le câble sous-marin et, le cas échéant, deux extrémités ouvertes des fibres optiques (25, 26) sont reliées ensemble dans le manchon de câble sous-marin (10).

4. Tronçon de câble sous-marin selon l'une des revendications précédentes, **caractérisé en ce qu'**au moins une bobine (28) est disposée autour d'au moins une portion de câble sous-marin (13, 14) pour la génération d'énergie électrique pour les convertisseurs de signaux (20, 21), l'au moins une bobine (28) étant reliée aux convertisseurs de signaux (20, 21) par un câble (29).

5. Tronçon de câble sous-marin selon l'une des revendications précédentes, **caractérisé en ce que** les capteurs capacitifs (15, 16) sont réalisés sous la forme de tôles métalliques ou de films métalliques, de préférence des tôles en cuivre ou des films en cuivre, qui peuvent au moins partiellement être posés autour d'un pourtour des portions de câble sous-marin (13, 14).

6. Tronçon de câble sous-marin selon l'une des revendications précédentes, **caractérisé en ce qu'**un générateur d'impulsions destiné à générer une impulsion de calibrage électrique définie est associé à au moins une extrémité du câble sous-marin.

7. Tronçon de câble sous-marin selon l'une des revendications précédentes, **caractérisé en ce que** le manchon de câble sous-marin (10) est un manchon de câble sous-marin monoconducteur à haute tension ou un manchon de câble sous-marin à trois conducteurs à haute tension.

8. Procédé de détermination de décharges partielles électriques dans un tronçon de câble sous-marin comprenant un manchon de câble sous-marin (10), par le biais duquel les extrémités (11, 12) de deux portions de câble sous-marin (13, 14) d'un câble sous-marin sont reliées ensemble, une ou chaque décharge partielle dans le manchon de câble sous-marin (10) étant mesurée par deux capteurs capacitifs (15, 16) devant et derrière les deux côtés du manchon de câble sous-marin (10), une position de la décharge partielle respective dans le manchon de câble sous-marin (10) étant déterminée par un dispositif de mesure (24) à l'aide des signaux électriques des capteurs capacitifs (15, 16), les deux capteurs capacitifs (15, 16) étant fixés devant et derrière le manchon de câble sous-marin (10) aux deux portions de câble sous-marin (13, 14) et les capteurs (15, 16) étant séparés des portions de câble sous-marin (13, 14) par un diélectrique et étant revêtus d'une enveloppe protectrice, et les signaux électriques des capteurs (15, 16) étant transportés par des câbles (18, 19) vers des convertisseurs de signaux (20, 21) et les signaux électriques mesurés étant convertis par les convertisseurs de signaux (20, 21) en signaux optiques, lesquels sont transportés au dispositif de mesure (24) par des fibres optiques (22, 23, 25, 26).

9. Procédé selon la revendication 8, **caractérisé en ce qu'**avant la mise en service du câble sous-marin, celui-ci est soumis à au moins une impulsion électrique définie pour le calibrage du dispositif de mesure (24) et la décharge partielle est détectée par les capteurs capacitifs (15, 16) en-dehors du manchon (10).

10. Procédé selon la revendication 8 ou 9, **caractérisé en ce que** pendant le fonctionnement du câble sous-marin, les décharges partielles qui sont générées par un courant électrique, de préférence un courant alternatif, appliqué au câble sous-marin, sont détectées par les capteurs capacitifs (15, 16) en-dehors du manchon (10).

11. Procédé selon l'une des revendications 8 à 10, **caractérisé en ce que** les positions des décharges partielles dans le manchon de câble sous-marin (10) sont déterminées par le dispositif de mesure (24) par une mesure du temps de propagation des signaux mesurés des décharges partielles aux capteurs (15, 16).

12. Procédé selon l'une des revendications 8 à 11, **caractérisé en ce que** les signaux électriques mesurés par les capteurs capacitifs (15, 16) dans le cas d'une décharge partielle sont convertis en signaux optiques par des convertisseurs de signaux (20, 21), lesquels sont transportés par le câble sous-marin jusqu'au dispositif de mesure (24), les signaux électriques étant transportés des capteurs (15, 16) aux convertisseurs de signaux (20, 21) par des câbles (18, 19), de préférence des câbles BNC.

13. Procédé selon l'une des revendications 8 à 12, **caractérisé en ce que** l'énergie électrique servant à l'alimentation des convertisseurs de signaux (20, 21) est générée par au moins une bobine (28) qui est disposée autour d'au moins une extrémité d'une portion de câble sous-marin (13, 14) du câble sous-marin.
